# FASCICULE DE BREVET EUROPEEN

(11) **EP 3 864 751 B1**
(45) Date de publication et mention de la délivrance du brevet: **08.07.2026**
(21) Numéro de dépôt: 19779923.2
(22) Date de dépôt: 07.10.2019
(51) Int. Cl.: H03F 3/68, H03F 3/24, H03F 1/32, H03F 3/21, H04B 1/04

(54) **SYSTEME D'EMISSION MULTI-VOIES AUTO CALIBRE POUR CHARGE UTILE DE SATELLITE**
SELBSTKALIBRIERENDES MEHRKANALÜBERTRAGUNGSSYSTEM FÜR EINE NUTZLAST EINES SATELLITEN
SELF-CALIBRATED MULTI-CHANNEL TRANSMISSION SYSTEM FOR A SATELLITE PAYLOAD

(30) Priorité: 11.10.2018 FR 1801072
(43) Date de publication de la demande: 18.08.2021
(73) Titulaire: THALES, 92400 Courbevoie (FR)
(72) Inventeur: OSTER, Yann, 31037 Toulouse Cedex (FR); LECOINTRE, Aubin Michel, 31037 Toulouse Cedex (FR); BRIAND, Aline, 31037 Toulouse Cedex (FR)
(74) Mandataire: Atout PI Laplace
(86) Numéro de dépôt international: PCT/EP2019/077052
(87) Numéro de publication internationale: WO 2020/074428

(56) Documents cités:
- EP-A1- 2 383 887
- US-A1- 2012 163 428
- US-A1- 2012 319 772
- US-A1- 2015 249 462
- US-A1- 2017 005 894
- US-A1- 2018 183 397
- HAN LIM LEE ET AL: "Analysis of multi-port amplifier calibration for optimal magnitude and phase error detection", IET MICROWAVES, ANTENNAS & PROPAGATION, THE INSTITUTION OF ENGINEERING AND TECHNOLOGY, UNITED KINGDOM, vol. 10, no. 1, 1 January 2016 (2016-01-01), pages 102 - 110, XP006106801, ISSN: 1751-8725, DOI: 10.1049/IET-MAP.2015.0237
- XINPING HUANG ET AL: "Benefit of linearizing power amplifiers in multi-port amplifier subsystems", CIRCUITS AND SYSTEMS, 2008. ISCAS 2008. IEEE INTERNATIONAL SYMPOSIUM ON, IEEE, PISCATAWAY, NJ, USA, 18 May 2008 (2008-05-18), pages 1260 - 1263, XP031392209, ISBN: 978-1-4244-1683-7, DOI: 10.1109/ISCAS.2008.4541654

## Description

L'invention concerne le domaine de la calibration de chaînes d'émission radio-fréquence et de la calibration des amplificateurs multi-voies ou multi-ports notamment, mais pas uniquement, pour la formation de faisceaux d'antennes dans une charge utile de satellite.

L'invention a pour objet un système émetteur multi-voies comprenant un tel amplificateur multi-ports et qui comporte une fonctionnalité de calibration intégrée pour corriger les défauts des réponses fréquentielles des chaînes en émission radio-fréquence, pour les appairer afin d'optimiser l'isolation entre voies du système.

La problématique générale visée par l'invention concerne la correction de défauts entre différentes voies d'un système d'émission multi-voies comprenant, pour chaque voie, une chaine de traitement radiofréquence comprenant au moins un filtre et une transposition en fréquence, et un amplificateur multi-ports. Les défauts à corriger sont des défauts impactant les réponses fréquentielles des chaînes d'émission radio-fréquence, l'appairage de ces chaînes entre elles ainsi que des défauts d'isolation de l'amplificateur multi-ports.

Un tel système d'émission multi-voies nécessite une calibration précise de l'ensemble des voies afin de corriger les déphasages et les différences de gain sur toute la bande de fréquence utile, qui impactent les signaux en sortie de chaque voie. Ces défauts proviennent des défauts inhérents aux composants analogiques qui ne sont pas tous strictement identiques et qui ne présentent pas les mêmes comportements en fonction de la température, du vieillissement ou de l'exposition aux radiations ionisantes.

Un amplificateur multi-ports est composé d'un réseau hybride d'entrée et d'un réseau hybride de sortie dont les fonctions de transfert doivent être réciproques. Quelle que soit la technologie hyper-fréquence utilisée pour réaliser les réseaux hybrides, il est très difficile d'assurer une réciprocité parfaite des fonctions de transfert. Ainsi, des erreurs d'isolation proviennent également des défauts de fabrication de ces composants. Les défauts d'isolation d'un amplificateur multi-ports proviennent aussi des défauts d'appairage des amplificateurs élémentaires

En outre, les défauts d'isolation ne sont pas forcément identiques dans toute la bande de fréquence utile du système. Ces défauts d'isolation engendrent d'une part des fuites des signaux entre les différents ports de sortie, et d'autre part des pertes d'amplification.

Il existe donc un besoin pour calibrer dynamiquement et sans interruption de service un ensemble de chaines radiofréquence en émission utilisant un amplificateur multi-ports, afin d'appairer précisément les voies entre elles et de corriger les défauts d'isolation de l'amplificateur multi-ports.

Différentes solutions existent pour corriger les défauts des réponses fréquentielles des chaines d'émission radiofréquence ainsi que les défauts d'isolation entre voies d'un amplificateur multi-ports.

Une première solution consiste à sur-contraindre la spécification de chaque composant ou équipement de la chaîne de traitement, afin que la somme des dispersions de l'ensemble des composants reste compatible du niveau de performance souhaité, pour la mission envisagée. Autrement dit, il s'agit de concevoir les composants du système avec des plages de tolérance ou des marges réduites.

Cette technique ne réalise pas de calibration et présente l'inconvénient d'augmenter significativement les coûts de conception du système. Par ailleurs, les dispersions résiduelles n'étant pas compensées dynamiquement, elles peuvent évoluer au cours du temps et restent ainsi non négligeables.

Une autre solution consiste à caractériser le comportement des composants ou équipements du système, en termes de sensibilité à la température et/ou à la tension d'alimentation ou à d'autres paramètres, puis à implanter une fonction de compensation statique des défauts en fonction de ces paramètres. Ce type de calibration permet une correction statique basée sur la mesure ou sur l'estimation de ces paramètres, sans capacité d'adaptation aux écarts réels qui peuvent évoluer, en particulier du fait du vieillissement et de l'effet des radiations.

Une autre solution consiste à estimer les écarts des réponses fréquentielles sur les différentes chaines d'émission radio-fréquence, en utilisant un signal de calibration maitrisé, injecté en entrée du système et extrait en sortie. La déformation du signal de calibration en sortie de chaîne permet d'estimer la réponse spectrale en temps réel, et de compenser les défauts moyennant une boucle de rétroaction. Ce type de solution bouclée, dynamique, permet de s'adapter aux défauts des réponses fréquentielles, indépendamment de leur origine.

Cependant, cette solution nécessite de pouvoir injecter et extraire le signal de mesure pour la calibration.

Une première option consiste à interrompre le service rendu par le système, par exemple un service de télécommunications, pendant la calibration pour générer un signal de calibration. Cette solution présente l'inconvénient de l'interruption de service.

Une deuxième option consiste à réduire la puissance du signal de calibration afin de le superposer au signal utile de manière imperceptible, pour éviter l'interruption du service. Dans ce cas, la mesure du signal de calibration extrait est affectée par un faible rapport signal à bruit limitant la précision de calibration.

Une troisième option consiste à étaler le spectre du signal de calibration afin de le superposer au signal utile de manière imperceptible, afin d'éviter l'interruption du service. Dans ce cas, la mesure du signal de calibration extrait est affectée par un rapport signal à bruit moyen et par l'étalement du point en fréquence. L'estimation des défauts correspond à une moyenne des défauts sur la bande d'étalement de fréquence, limitant la résolution fréquentielle de la calibration.

Une quatrième solution consiste à transmettre le signal de calibration sur des fréquences non utilisées par les signaux utiles au service, afin d'éviter les interférences entre signal de calibration et signaux utiles. Cette solution permet de réaliser des mesures précises avec un bon rapport signal à bruit du signal de calibration, mais avec une mauvaise résolution fréquentielle, le signal de calibration ne couvrant pas toute la bande de fréquence utile.

Une autre solution, décrite dans la demande de brevet européenne EP2383887 consiste, pour un amplificateur multi-ports muni de coupleurs sur toutes les sorties du réseau hybride de sortie, à générer des signaux avec des fréquences particulières différentes sur les diverses entrées de l'amplificateur afin d'estimer les disparités en gain et en phase en fonction de la fréquence et sur les différentes voies. Cette technique impose une interruption du trafic pendant la calibration. Un signal de calibration spécifique est injecté sur toutes les entrées du réseau d'entrée de l'amplificateur.

On connait encore la solution décrite dans la demande de brevet européenne EP2800271. Cette solution consiste à compenser de manière adaptative chaque amplificateur unitaire d'un amplificateur multi-ports avec un point de contrôle en gain et en phase par amplificateur, de manière à minimiser l'inter-corrélation entre les différents signaux de sortie de l'amplificateur. Un processeur numérique réalise les traitements de corrélation sur deux chaines d'acquisition sélectionnant des paires de sorties de l'amplificateur multi-ports. Cette solution peut être utilisée sans interruption du trafic, à condition que les différents signaux à émettre soient décorrélés, ce qui n'est pas le cas en général notamment lorsqu'une antenne active est utilisée en sortie de l'amplificateur. De plus, cette technique ne couvre pas la compensation des erreurs d'isolation sur une large bande de fréquence et ne compense pas les défauts des réponses fréquentielles des chaines de conversion de fréquence.

On connait encore la publication scientifique « Analysis of multi-port amplifier calibration for optimal magnitude and phase detection » (Han Lim Lee et al) qui distingue les dispositifs de calibration pour des amplificateurs multi-ports selon la position des coupleurs de mesure en entrée ou en sortie du réseau hybride de sortie. La calibration est réalisée en l'absence de trafic. La compensation des défauts d'appairage des amplificateurs élémentaires de l'amplificateur multi-ports est réalisée par un amplificateur et par un déphaseur analogiques, pour une seule fréquence, sur commande d'une unité de calcul. Cette technique impose l'interruption de service, elle ne permet pas de corriger les défauts d'isolation sur toute la bande de fréquence utile du système, et ne couvre pas la calibration des chaînes radio-fréquence.

On connait encore un amplificateur auto-calibré du type décrit dans la demande de brevet américaine du demandeur US 2012/0280748. Cette solution consiste à injecter un signal de calibration sur une voie d'entrée de l'amplificateur en le superposant au signal utile. La méthode proposée ne prend pas en compte les distorsions entre les réponses en fréquence des chaines de conversion. Le signal de calibration n'est pas éliminé en sortie de l'amplificateur, il est donc rayonné et doit être discret ce qui impose un faible rapport signal à bruit sur ce signal ou l'utilisation d'étalement de spectre. Les défauts d'isolation ne sont corrigés que pour une seule fréquence et ne permettent pas une correction sur toute la bande de fréquence du signal utile.

On connait également les solutions décrites dans les demandes de brevet US2015/249462, US2017/005894, US2018/183397, US2012/319772, EP2383887, US 2012/163428, « Analysis of multi-port amplifier calibration for optimal magnitude and phase error detection, Han Lim Lee et al », « Benefit of linearizing power amplifiers in multiport amplifier subsystems, Xinping Huang et al »

De manière générale, les solutions connues impliquent une interruption du service rendu par le système d'émission multi-voies, par exemple un service de télécommunications.

Certaines solutions permettent une calibration sans interruption de service mais impliquent une réduction de la précision de calibration à cause d'un faible rapport signal à bruit du signal de calibration ou du fait d'une faible résolution fréquentielle pour l'estimation des défauts. Les solutions connues de calibration pour chaines radiofréquence et pour amplificateurs multi-ports, sans interruption de service, conduisent à l'émission du signal de calibration qui est susceptible d'interférer avec les signaux utiles.

L'invention permet de résoudre les inconvénients des solutions précitées en proposant un système d'émission multi-voies qui inclut une fonctionnalité de calibration qui permet de réaliser une calibration précise des chaînes de conversion de fréquence et de l'amplificateur multi-ports du système sans interruption de service. La calibration proposée permet de corriger les défauts sur toute la bande de fréquence du système.

L'invention a pour objet un système d'émission multi-voies tel que défini dans la revendication 1.

Selon un aspect particulier de l'invention, le réseau hybride d'entrée est configuré pour recevoir le signal de calibration sur une entrée de calibration et un signal utile sur les autres entrées et le réseau hybride de sortie comporte une sortie de calibration connectée à une charge et les autres sorties connectées à une ou plusieurs antennes.

Selon un aspect particulier de l'invention, le signal de calibration est superposé à un signal utile sur une entrée du réseau hybride d'entrée.

Selon un aspect particulier de l'invention, le signal de calibration est un signal large bande ou un signal bande étroite ayant une bande de fréquence variant temporellement dans toute la bande de fréquence du système.

Selon un aspect particulier de l'invention, le signal de calibration est périodique et l'extraction d'une mesure du signal de calibration est réalisée en effectuant une accumulation temporelle cohérente du signal reçu sur l'entrée de calibration.

Selon un aspect particulier de l'invention, le signal de calibration est égal à un signal utile généré sur une entrée du réseau hybride d'entrée et sauvegardé dans une mémoire.

Selon un aspect particulier de l'invention, chaque filtre égaliseur est configuré pour corriger, sur toute la bande de fréquence du système, en amplitude et en phase les signaux de sortie du réseau hybride d'entrée de manière à corriger les défauts d'appairage et d'isolation des différentes voies du système d'émission multi-voies.

Selon un aspect particulier de l'invention, chaque chaine de traitement analogique radiofréquence comprend un dispositif de transposition de fréquence pour transposer le signal analogique d'une première fréquence vers une seconde fréquence et la chaine d'acquisition analogique radiofréquence comprend un dispositif de transposition de fréquence inverse pour transposer un signal analogique de la seconde fréquence vers la première fréquence.

L'invention a aussi pour objet une charge utile de satellite comprenant un système d'émission multi-voies selon l'invention et au moins une antenne ou réseau antennaire connecté en sortie dudit système.

D'autres caractéristiques et avantages de la présente invention apparaîtront mieux à la lecture de la description qui suit en relation aux dessins annexés qui représentent :
- La figure 1, un schéma d'un système d'émission multi-voies avec amplificateur multi-ports selon l'art antérieur,
- La figure 2a, un schéma d'un système d'émission multi-voies avec amplificateur multi-ports selon un premier mode de réalisation de l'invention,
- Les figures 2b, 2c et 2d, trois schémas représentant deux variantes du système de la figure 2a,
- La figure 3, un synoptique illustrant la mise en œuvre d'un algorithme d'optimisation dans le domaine temporel pour le calcul des coefficients d'un filtre d'égalisation,
- La figure 4, un synoptique illustrant la mise en œuvre d'un algorithme d'optimisation dans le domaine fréquentiel pour le calcul des coefficients d'un filtre d'égalisation,
- La figure 5, un schéma d'un système d'émission multi-voies avec amplificateur multi-ports selon un second mode de réalisation de l'invention,
- La figure 6, un schéma d'un système d'émission multi-voies avec amplificateur multi-ports selon un troisième mode de réalisation de l'invention.

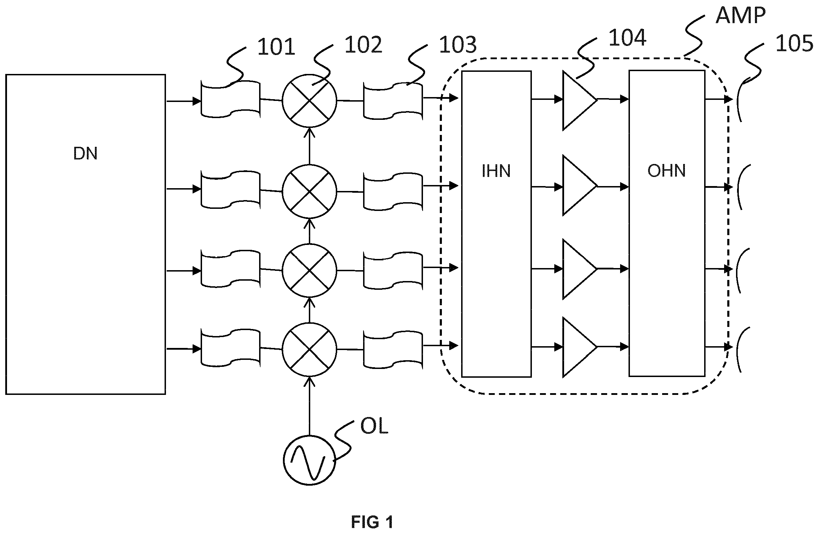

La figure 1 représente un exemple de système d'émission multi-voies avec amplificateur multi-ports de l'art antérieur. Un tel système comporte un dispositif numérique DN pour générer ou traiter des signaux numériques provenant d'un utilisateur ou d'une station au sol ou d'un autre satellite. Les signaux numériques sont convertis analogiquement par un ou plusieurs convertisseurs numérique-analogique (non représentés sur la figure 1). Le système de la figure 1 comporte plusieurs voies d'émission radio-fréquence (quatre voies sur l'exemple décrit). Pour chacune des voies d'émission radio-fréquence, une chaine analogique de conversion de fréquence permet de filtrer le signal et de transposer le signal sur une fréquence porteuse d'émission. Une telle chaine de conversion de fréquence comporte un ou plusieurs filtres analogiques 101,103 et un mélangeur 102. Les signaux analogiques sont ensuite produits en entrée d'un amplificateur multi-ports AMP en vue de l'amplification de puissance.

Un amplificateur multi-ports AMP est une structure qui permet de partager un ensemble de N amplificateurs élémentaires pour amplifier un ensemble de N signaux entrants sur N ports d'entrée, et sortants après amplification sur N ports de sortie. Dans un fonctionnement idéal, l'isolation des signaux est garantie sur les ports de sortie. La structure d'un amplificateur multi-ports consiste en un réseau hybride d'entrée IHN, un ensemble d'amplificateurs élémentaires appairés 104, et un réseau hybride de sortie OHN.

Un réseau hybride est un dispositif de multiplexage qui reçoit plusieurs signaux sur ses entrées multiples et applique une loi de combinaison et de déphasage des signaux d'entrées pour produire autant de signaux de sortie. Autrement dit, chaque signal de sortie du réseau hybride IHN est égal à une combinaison linéaire complexe des signaux d'entrée déphasés selon une loi de phase donnée. Le réseau hybride applique aux signaux d'entrée une fonction de transfert particulière. Il peut prendre la forme, par exemple, d'une matrice de Butler. Un amplificateur élémentaire 104 est connecté à chaque sortie du réseau hybride d'entrée IHN. Puis un réseau hybride de sortie OHN, ou « Output Hybrid Network » en anglais, est disposé après les amplificateurs pour appliquer la fonction de transfert inverse de celle du réseau hybride d'entrée IHN. L'amplificateur multi-ports AMP permet de gérer finement l'allocation de puissance sur chaque voie du système. Par exemple, la totalité de la puissance maximale des quatre amplificateurs peut être allouée à une seule voie, ce qui ne serait pas possible avec un amplificateur élémentaire par voie.

En sortie de l'amplificateur multi-ports AMP, une ou plusieurs antennes 105 sont disposées pour rayonner les signaux amplifiés. Il peut s'agir d'antennes passives, chaque antenne comprenant une source, par exemple un cornet, excité par un signal d'une voie du système pour former un faisceau. Dans ce cas, le système d'émission comprend une antenne pour chaque voie, chaque antenne étant connectée à une sortie de l'amplificateur multi-ports. Les antennes passives peuvent aussi être remplacées par une antenne active ou un réseau antennaire qui comporte plusieurs sources qui rayonnent en parallèle et sont excitées par l'ensemble des signaux de sortie de l'amplificateur multi-ports selon une loi de phase permettant de former plusieurs faisceaux dans plusieurs directions. Dans le cas d'une antenne active, toutes les chaînes de transposition de fréquence utilisent un même oscillateur local afin de garantir la cohérence de phase des signaux après leur transposition de fréquence.

Le système de la figure 1 présente les inconvénients déjà discutés des défauts des réponses fréquentielles des chaînes radio-fréquence et des défauts d'isolation entre les différentes voies.

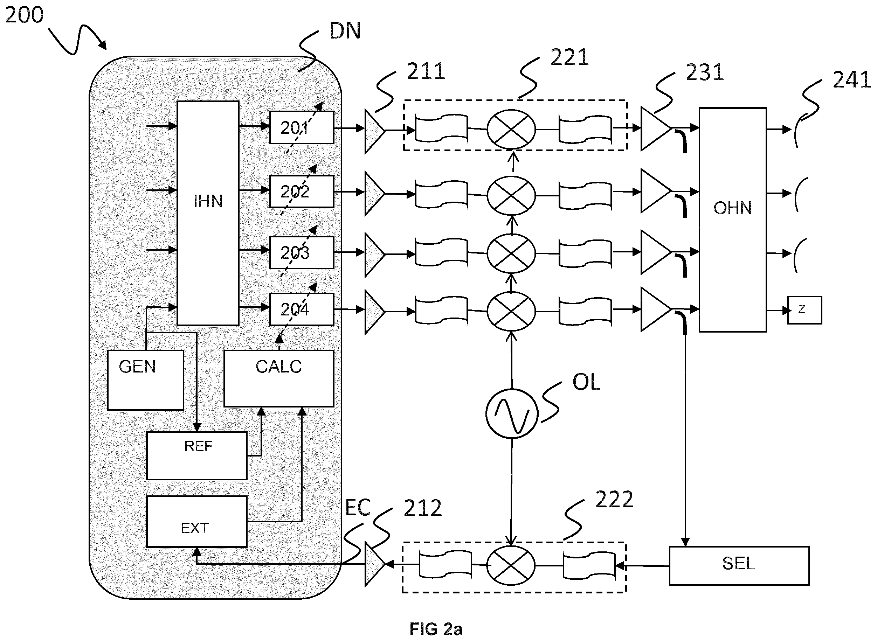

La figure 2a décrit un exemple d'un système d'émission multi-voies 200 selon un premier mode de réalisation de l'invention.

Le système 200 comprend certains éléments communs au système de la figure 1. En particulier, le système 200 comprend plusieurs voies d'émission (quatre voies sur l'exemple de la figure 2a) comprenant chacune une chaine de conversion de fréquence 221 analogique et un amplificateur 231. Un réseau hybride de sortie OHN, préférentiellement réalisé en technologie guide d'ondes, est connecté aux sorties des quatre amplificateurs 231. Sans sortir du cadre de l'invention, chaque chaine de conversion de fréquence 221 peut aussi comprendre un ou plusieurs filtres disposés entre un amplificateur 231 et une entrée du réseau hybride de sortie OHN. Autrement dit les entrées du réseau hybride de sortie OHN sont connectées directement ou indirectement, par l'intermédiaire de filtres ou d'autres composants, aux sorties des amplificateurs 231.

Pour corriger les défauts des réponses fréquentielles des voies et pour optimiser l'isolation des voies après amplification par l'amplificateur multi-ports, l'invention met en œuvre un mécanisme de calibration qui vient piloter un ensemble de filtres numériques (un filtre par voie) 201-204 qui ont pour fonction de corriger les signaux en phase et en amplitude pour qu'en sortie du réseau hybride de sortie OHN, les signaux produits sur les antennes 241 soient amplifiés sans distorsion fréquentielle induite par les chaines de conversion de fréquence 221 et sans interférence induite par les autres voies. Les filtres numériques sont appliqués aux signaux de sortie du réseau hybride d'entrée IHN.

Pour cela, l'invention consiste à déporter le réseau hybride d'entrée IHN, ou plus généralement la fonction réalisée par le réseau hybride d'entrée IHN, dans le dispositif numérique DN en amont des chaines de conversion de fréquence 221. Un avantage à la réalisation numérique du réseau hybride d'entrée est qu'elle permet d'implémenter très précisément la fonction de transfert inverse du réseau hybride de sortie OHN qui est parfaitement connue après fabrication. En outre, le réseau hybride de sortie OHN, lorsqu'il est fabriqué en technologie guide d'ondes, présente une fonction de transfert stable dans le temps, ce qui permet ainsi d'assurer une stricte réciprocité des fonctions de transfert respectives du réseau hybride d'entrée IHN numérique et du réseau hybride de sortie OHN.

Les signaux à transmettre sont donc produits directement sur les entrées du réseau hybride d'entrée IHN, puis sont égalisés par un filtre 201-204 configuré pour corriger les défauts des réponses fréquentielles des voies afin d'appairer les voies entre elles et de corriger les défauts d'isolation de l'amplificateur multi-ports. Les signaux numériques filtrés par 201-204 sont fournis en sortie du dispositif numérique DN à des convertisseurs numérique-analogique 211 puis aux chaines de conversion de fréquence 221.

Pour assurer la calibration des voies, le système 200 utilise un port d'entrée dédié du réseau hybride d'entrée IHN sur lequel est injecté un signal de calibration périodique généré par un dispositif numérique GEN. Le signal de calibration est distribué sur toutes les voies, selon la fonction de transfert du réseau hybride d'entrée IHN, puis est propagé en sortie du réseau hybride de sortie OHN sur une seule sortie qui est connectée à une charge z. Les autres sorties du réseau hybride de sortie OHN sont connectées aux antennes 241. Les défauts éventuels d'appairage des fonctions situées entre les réseaux hybrides d'entrée et de sortie conduisent à des défauts d'isolation et à des gains réduits observables sur les ports de sortie.

Le signal de calibration est choisi pour occuper toute la bande spectrale utile du système. Par exemple, il peut s'agir d'un signal large bande ou bien d'un signal bande étroite dont la fréquence est rendue variable pour balayer toute la bande spectrale utile au cours du temps selon une séquence temporelle prédéfinie.

Le système 200 comporte en outre un sélecteur SEL apte à sélectionner successivement et de manière séquentielle chaque sortie d'un amplificateur 231 pour chaque voie l'une après l'autre et périodiquement.

Le signal prélevé en sortie d'un amplificateur est ensuite transmis à une chaine de conversion de fréquence 222 qui réalise la fonction inverse des chaines de conversion de fréquence 221 de chaque voie du système. Toutes les chaînes de conversion de fréquence 222 et 221 utilisent un même oscillateur local OL. Un convertisseur analogique-numérique 212 numérise ensuite le signal pour le fournir au dispositif numérique DN sur une entrée de calibration EC.

Un premier composant EXT ou fonction du dispositif numérique DN permet d'extraire du signal disponible sur l'entrée de calibration EC, une mesure du signal de calibration. La mesure du signal de calibration correspond au signal de calibration qui a été injecté en entrée du système et qui, après avoir traversé les différents composants du système, est soumis aux mêmes perturbations et défauts que les signaux utiles.

Cette extraction est, par exemple, réalisée en décomposant le signal reçu en séquences temporelles consécutives de N échantillons, avec N la période du signal de calibration. Ces séquences sont ensuite accumulées ou moyennées entre elles. Les signaux utiles étant décorrélés du signal de calibration, cette accumulation ou moyennage des N séquences permet d'extraire le signal de calibration du signal reçu sur l'entrée de calibration EC, les contributions des signaux utiles tendant à s'annuler. D'autres méthodes peuvent être utilisées pour réaliser l'extraction d'un signal de calibration connu, qu'il soit périodique ou non périodique parmi lesquelles on peut citer, sans être exhaustif, des méthodes par filtrage adapté, par corrélation ou encore par dés-étalement de spectre.

Lorsque le signal de calibration est extrait du signal reçu sur l'entrée de calibration EC, celui-ci est affecté des défauts de la voie sur laquelle il a été mesuré. Il est ensuite comparé au signal de calibration généré qui a été éventuellement retardé (par une ligne à retard numérique REF) pour prendre en compte le temps de parcours du signal à travers le système 200. Un algorithme d'optimisation permet de déterminer les coefficients d'un filtre correcteur 201-204 sur la base de la comparaison du signal de calibration de référence et du signal de calibration après extraction sur le signal disponible sur l'entrée de calibration, afin de minimiser l'écart entre ces deux signaux.

Le critère de comparaison dépend de l'algorithme d'optimisation utilisé, il peut consister en une comparaison dans le domaine temporel ou dans le domaine fréquentiel. De façon générale, ce critère vise à minimiser directement ou indirectement, dans le domaine temporel ou fréquentiel, l'écart entre ces deux signaux.

Les coefficients du filtre sont déterminés de sorte à minimiser la différence entre le signal de calibration généré et le signal de calibration extrait de la mesure en sortie de l'amplificateur de chaque voie. Cet appairage conduit à l'égalisation de la réponse fréquentielle de la voie considérée incluant la chaîne de conversion de fréquence et l'amplificateur élémentaire. Chaque filtre est configuré indépendamment et le processus est bouclé jusqu'à converger vers un régime stable pour lequel les défauts sont corrigés et le signal de calibration mesuré est identique au signal de calibration généré. Lorsque toutes les voies ont été calibrées relativement à une même référence REF, elles sont alors de fait appairées entre elles et l'isolation des signaux sur les ports de sortie du réseau hybride de sortie OHN est optimale.

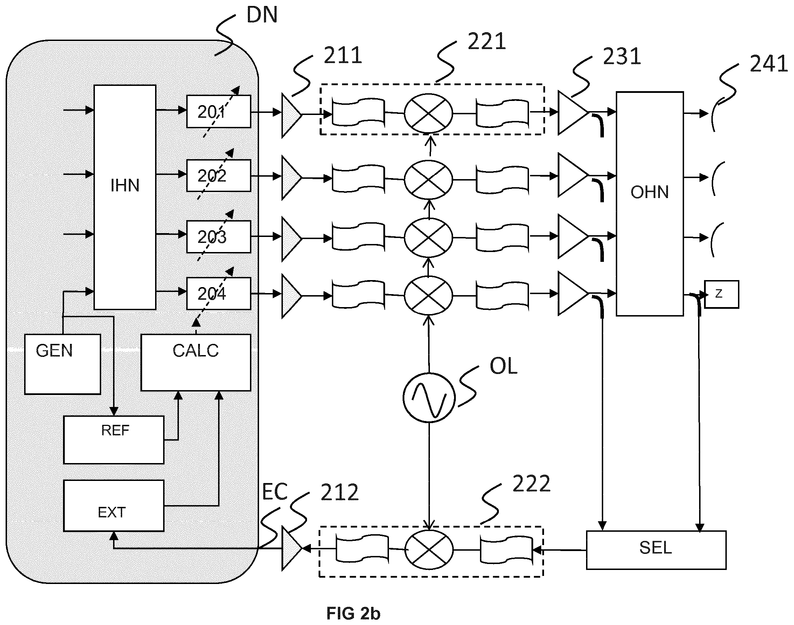

Dans une variante de réalisation, le signal de calibration peut aussi être mesuré sur la sortie du réseau hybride de sortie OHN connectée à la charge z afin d'évaluer l'isolation des voies en mesurant le rapport signal à bruit du signal de calibration relativement à la puissance des signaux d'entrée. Cette variante est représentée sur la figure 2b.

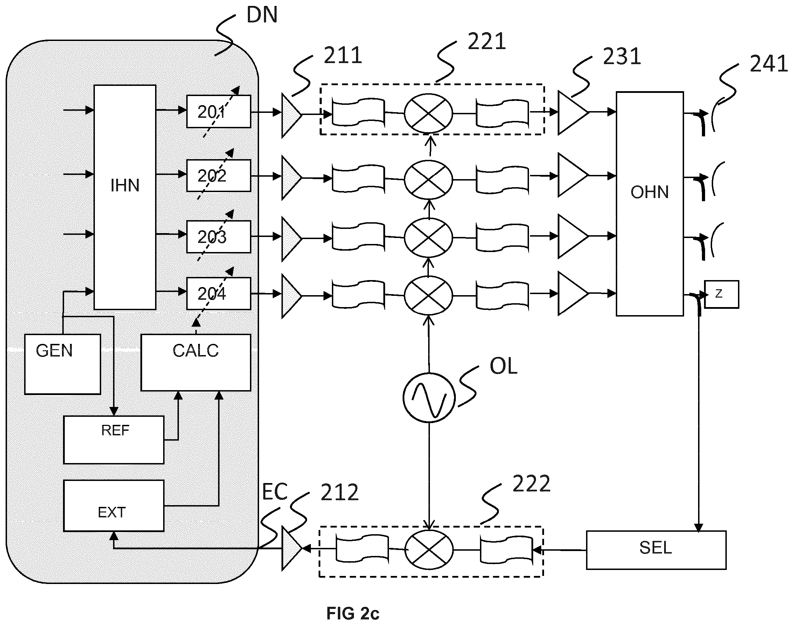

Dans une autre variante de réalisation, le sélecteur SEL prélève les signaux non plus en entrée du réseau hybride de sortie OHN mais en sortie, de sorte à prendre en compte les défauts éventuels du réseau hybride de sortie OHN. Cette variante est représentée sur la figure 2c.

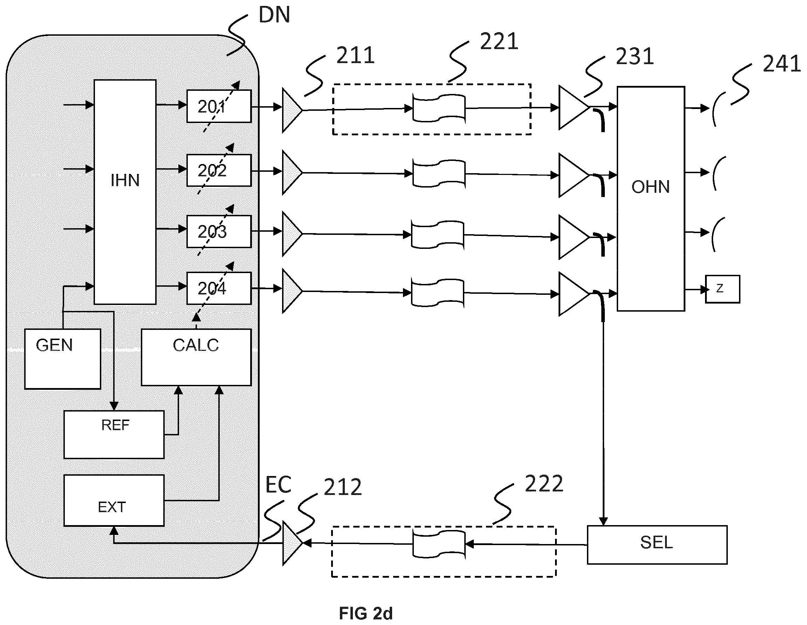

La figure 2d décrit une autre variante de réalisation de l'invention dans laquelle la fonction de conversion de fréquence est réalisée conjointement par le dispositif numérique, par exemple en amont du réseau hybride d'entrée IHN, et par le convertisseur numérique-analogique générant des répliques spectrales, et par filtrage analogique pour sélectionner une réplique spectrale. Cette technique de conversion avec transposition de fréquence est connue sous le terme « sous-échantillonnage » (« under-sampling », « bandpass sampling » en anglais). Dans ce cas, les chaines radiofréquence 221 comprennent uniquement un ou plusieurs filtres analogiques en vue de filtrer les composantes spectrales non souhaitées qui sont générées par les convertisseurs numériques-analogique 211. La chaine d'acquisition 222 inverse comporte le ou les mêmes filtres qu'une chaine radiofréquence directe 221. Le filtre de la chaine d'acquisition 222 permet de numériser la même bande de fréquence que celle des chaines radiofréquence 221. De façon générale, la chaine de traitement analogique 222 est une chaine d'acquisition du signal analogique prélevé par le sélecteur SEL et qui permet de sélectionner la bande de fréquence souhaitée avant la numérisation.

Les oscillateurs locaux analogiques sont supprimés. La variante décrite à la figure 2d est applicable pour toutes les variantes de mise en œuvre du système, en particulier celles décrites aux figures 2b et 2c.

Dans toutes les variantes de réalisation de l'invention, le mécanisme de calibrage mis en œuvre conduit également à compenser des défauts éventuels d'appairage des convertisseurs numérique-analogique 211.

On décrit à présent plusieurs exemples de mise en œuvre du calcul CALC des coefficients des filtres égaliseurs 201-204 à partir du signal de calibration généré GEN, d'une part, et du signal de calibration extrait EXT d'une mesure sur l'une des voies du système, d'autre part.

Chaque filtre numérique 201-204 est placé en amont des chaines analogiques d'émission dont on souhaite compenser les écarts d'isolation. Les filtres numériques sont indépendants de l'algorithme d'optimisation CALC utilisé pour calculer les coefficients. Différents algorithmes d'optimisation sont possibles.

L'algorithme d'optimisation peut opérer dans le domaine temporel ou dans le domaine fréquentiel, de manière itérative/récursive ou par bloc d'échantillons. Les algorithmes d'optimisation employés peuvent être indifféremment: des algorithmes de type moindres carrés comme par exemple les algorithmes LS (en anglais « Least Square »), LMS (en anglais « Least Mean Square »), RLS (en anglais « Recursive Least Squares »), des algorithmes utilisant des Transformée de Fourier (ou FFT), des covariances ou des corrélations, des algorithmes de type CMA (en anglais « Constant Modulus Algorithm»). Tous ces exemples d'algorithmes d'optimisation peuvent être utilisés pour déterminer les coefficients des filtres correcteurs 201-204.

Par la suite on décrit deux exemples de solution de calcul des coefficients des filtres numériques de compensation.

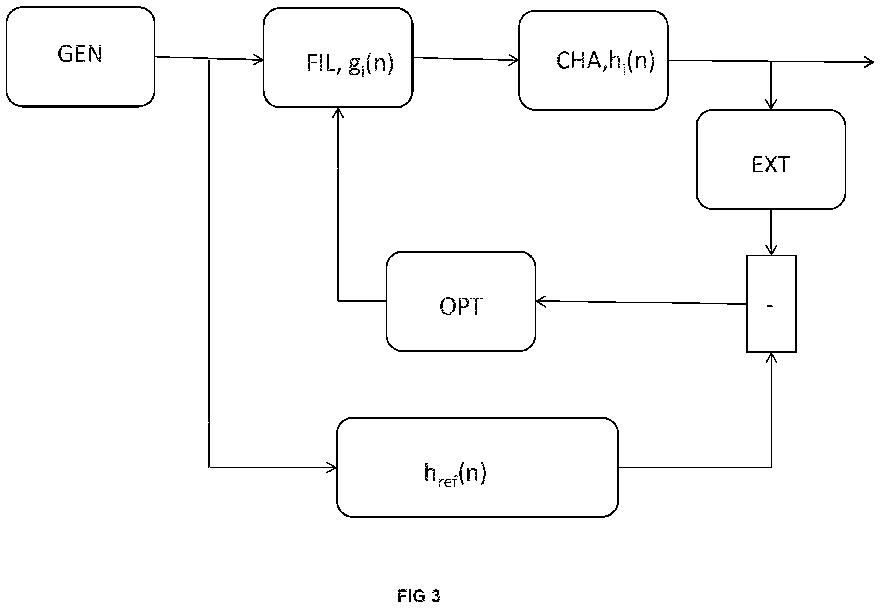

Un premier exemple est décrit pour une calibration dans le domaine temporel en utilisant un algorithme des moindres carrés. Pour illustrer cet exemple, on a schématisé, sur la figure 3, un synoptique d'un modèle de calibration d'une voie d'émission. Selon ce modèle, un signal de calibration est généré par un générateur GEN et transmis sur une voie d'émission du système. Sur chacune des voies, un filtre de compensation FIL est appliqué avec une fonction de transfert gᵢ(n) dans le domaine temporel. On note par ailleurs hᵢ(n) la fonction de transfert de la chaine de traitement analogique CHA à calibrer. Le signal de calibration est extrait, via une fonction d'extraction EXT, en sortie de la chaine de traitement puis est soustrait au signal de calibration en sortie d'une chaîne de référence REF définie par la fonction de transfert h_{ref}(n), cette fonction de transfert est par exemple égale à un retard. A partir de cette différence, l'algorithme d'optimisation OPT calcule la réponse impulsionnelle du filtre gᵢ(n), autrement dit ses coefficients.

Cet algorithme OPT détermine les coefficients du filtre qui permettent de minimiser la puissance de l'erreur entre le signal de calibration en sortie de la chaine de référence et le signal de calibration extrait en sortie de la fonction de transfert composite composée de la chaine de traitement analogique i à calibrer hᵢ(n) et du filtre correcteur associé gᵢ(n). Si la puissance de l'erreur en sortie est minimisée alors la fonction de transfert composite tend vers la fonction de transfert de référence. On a donc égalisé la fonction de transfert de la chaine analogique.

Pour déterminer la réponse du filtre, l'algorithme d'optimisation met par exemple en œuvre une méthode de type LS ou LMS.

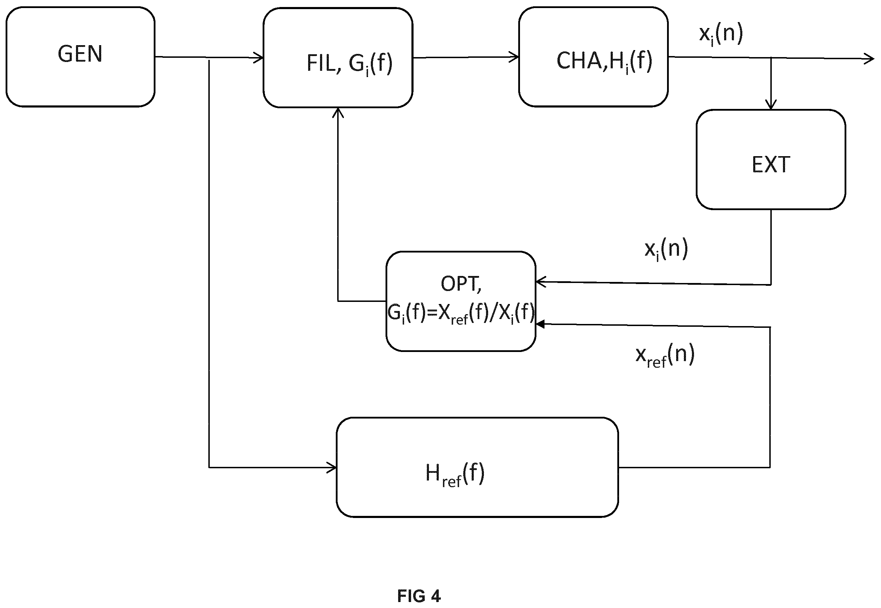

Un autre exemple d'algorithme d'optimisation est illustré à la figure 4. Il s'agit d'un algorithme d'optimisation dans le domaine fréquentiel. Cet algorithme utilise une transformée de Fourier pour déterminer le spectre des signaux traités. Autrement dit, on détermine le spectre Xᵢ(f) du signal extrait xᵢ(n) en sortie de la chaine de traitement analogique i et on détermine le spectre X_{ref}(f) du signal de calibration généré et auquel on a appliqué la fonction de transfert de référence H_{ref}(f). On peut alors déterminer la fonction de transfert du filtre FIL Gᵢ(f)= X_{ref}(f)/ Xᵢ(f) puis les coefficients du filtre par transformée de Fourier inverse appliquée à la fonction de transfert Gᵢ(f).

Ainsi, après calibration, on a bien Gᵢ(f). Hᵢ(f)= H_{ref}(f) et les défauts de la réponse fréquentielle de la chaine analogique i sont compensés.

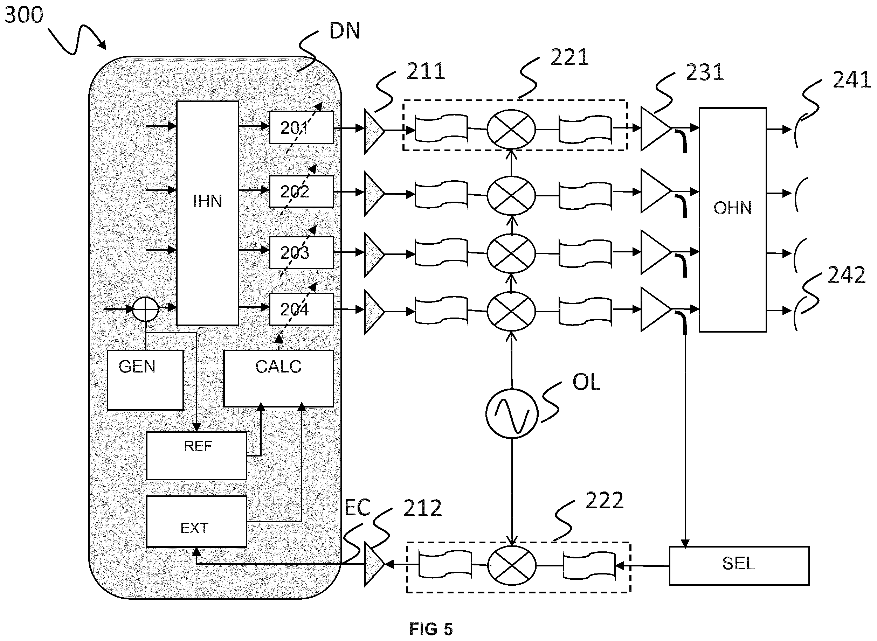

La figure 5 schématise une première variante 300 de réalisation du système selon l'invention.

Selon cette variante, le signal de calibration est injecté sur une voie du système, par superposition au signal utile. Autrement dit, dans le système 300 décrit à la figure 5, il n'y a plus d'entrée IHN et de sortie OHN dédiées à la calibration. Toutes les sorties du réseau hybride de sortie OHN sont connectées à une antenne 241,242 et toutes les entrées du système reçoivent un signal utile. Un avantage de cette variante est qu'elle permet l'exploitation de toutes les entrées et sorties des réseaux hybrides IHN et OHN sans nécessité d'en dédier deux pour la calibration.

Une contrainte à respecter pour cette variante est que le rapport signal à bruit du signal de calibration doit être réduit afin qu'il ne brouille pas le signal utile qui lui est superposé. Pour cela, la puissance du signal de calibration est réduite. Une solution pour améliorer le rapport signal à bruit du signal de calibration consiste à utiliser un signal de calibration avec étalement de spectre, au prix d'une moins bonne résolution fréquentielle.

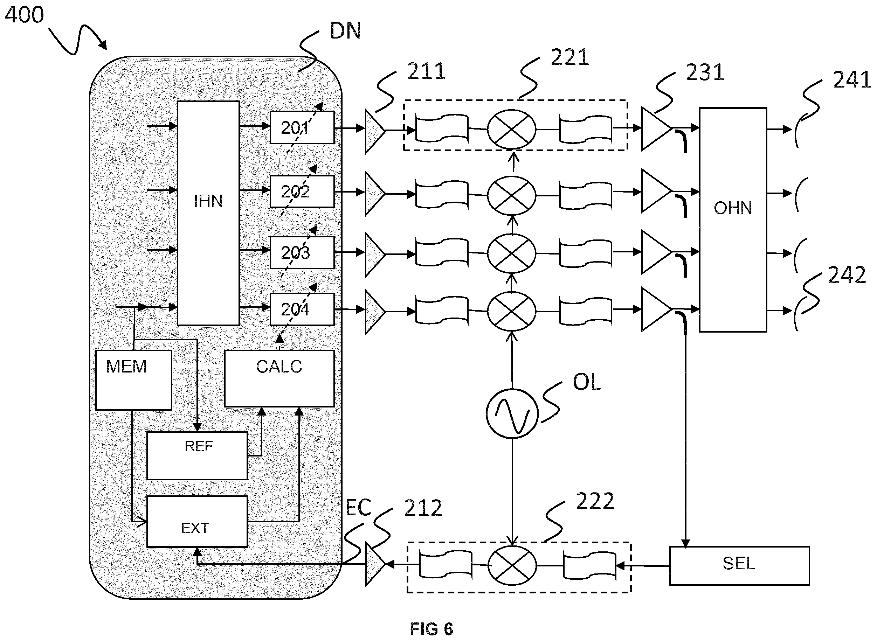

La figure 6 schématise une deuxième variante 400 du système selon l'invention.

Selon cette variante, le signal de calibration est remplacé par le signal utile transmis sur une voie d'entrée du système. Ce signal utile est mémorisé dans une mémoire MEM pour ensuite servir de signal de calibration, non périodique, utilisé afin d'être comparé au signal extrait du signal prélevé en sortie d'une voie de traitement.

Cette variante nécessite que le signal utile qui remplace le signal de calibration soit décorrélé des autres signaux utiles afin de pouvoir l'extraire du signal prélevé en sortie de chaque voie.

Le système selon l'invention peut être implémenté à l'aide de composants matériels et/ou logiciels. Les éléments logiciels peuvent être disponibles en tant que produit programme d'ordinateur sur un support lisible par ordinateur, support qui peut être électronique, magnétique, optique ou électromagnétique. Les éléments matériels peuvent être disponibles tous ou en partie, notamment en tant que circuits intégrés dédiés (ASIC) et/ou circuits intégrés configurables (FPGA) et/ou en tant que processeur de signal numérique DSP et/ou en tant que processeur graphique GPU, et/ou en tant que microcontrôleur et/ou en tant que processeur général par exemple.

En particulier, le dispositif numérique DN peut être mis en œuvre par un ensemble de circuits intégrés dédiés (ASIC) et/ou circuits intégrés configurables (FPGA) et/ou un processeur de signal numérique DSP ou un processeur général ou un processeur multi-cœurs ou un microcontrôleur. Les autres composants du système, en dehors du dispositif numérique DN, sont des composants analogiques.

L'invention présente notamment les avantages suivants. Elle permet de réaliser une calibration dynamique d'un système d'émission multi-voies sans interrompre le service rendu par le système, c'est-à-dire simultanément à l'émission des signaux utiles.

Contrairement aux solutions de l'art antérieur, l'invention permet de corriger non seulement les défauts d'isolation d'un amplificateur multi-ports mais aussi les défauts des réponses fréquentielles des chaines analogiques du système.

L'invention permet, grâce à l'utilisation de ports dédiés à la calibration, de réaliser le mécanisme de calibration avec une précision importante et sans impact sur le service. En effet, la puissance du signal de calibration peut être élevée puisque le signal de calibration n'interfère pas sur les signaux utiles en sortie du système. Le signal de calibration n'est pas rayonné.

La mise en œuvre d'un réseau hybride d'entrée numérique permet une réalisation précise de la fonction de transfert de ce réseau comme étant égale à la fonction de transfert inverse du réseau hybride de sortie. Ainsi, les défauts de symétrie entre les deux fonctions de transfert sont minimisés.

L'utilisation de filtres numériques pour compenser les défauts des réponses fréquentielles des chaines analogiques, associés à un signal de calibration qui occupe toute la bande spectrale du système permet de calibrer le système dans toute la bande de fréquence avec une résolution fréquentielle très fine.

## Revendications

1. Système (200,300,400) d'émission multi-voies comprenant un dispositif numérique (DN) configuré pour mettre en œuvre un réseau hybride d'entrée (IHN) à entrées multiples et sorties multiples et un filtre égaliseur (201,202,203,204) distinct pour chaque sortie du réseau hybride d'entrée (IHN), le système comprenant en outre :
- pour chaque sortie du dispositif numérique (DN) connectée à une sortie d'un filtre égaliseur respectif, un convertisseur numérique-analogique (211) suivi d'une chaine de traitement analogique radiofréquence (221), comprenant au moins un filtre analogique, et d'un amplificateur (231),
- un réseau hybride de sortie (OHN) dont chaque entrée est reliée à la sortie d'un amplificateur (231) différent,
- une chaine d'acquisition analogique radiofréquence (222) comprenant au moins un filtre analogique, la chaine d'acquisition analogique radiofréquence (222) étant connectée par son entrée, alternativement, à la sortie de chaque amplificateur (231) par l'intermédiaire d'un sélecteur (SEL), et par sa sortie à une entrée de calibration (EC) du dispositif numérique (DN) par l'intermédiaire d'un convertisseur analogique numérique (212), la chaine d'acquisition analogique radiofréquence (222) réalisant une fonction inverse à celle des chaines de traitement analogique radiofréquence (221),
le dispositif numérique (DN) étant en outre configuré pour :
- générer (GEN) un signal de calibration sur une entrée du réseau hybride d'entrée (IHN), le signal de calibration occupant toute la bande spectrale du système, des signaux utiles étant présents au moins sur les autres entrées du réseau hybride d'entrée (IHN),
- extraire (EXT), du signal reçu sur l'entrée de calibration, une mesure du signal de calibration,
- déterminer (CALC) successivement la réponse de chaque filtre égaliseur de manière à minimiser une différence entre le signal de calibration généré et le signal de calibration mesuré, le sélecteur (SEL) étant connecté successivement à la sortie de chaque amplificateur,
la fonction de transfert du réseau hybride d'entrée (IHN) est déterminée pour être la fonction de transfert inverse du réseau hybride de sortie (OHN).

2. Système (200) d'émission multi-voies selon la revendication 1 dans lequel le réseau hybride d'entrée (IHN) est configuré pour recevoir le signal de calibration sur une entrée de calibration et un signal utile sur les autres entrées et le réseau hybride de sortie (OHN) comporte une sortie de calibration connectée à une charge (Z) et les autres sorties connectées à une ou plusieurs antennes (241).

3. Système (300) d'émission multi-voies selon la revendication 1 dans lequel le signal de calibration est superposé à un signal utile sur une entrée du réseau hybride d'entrée (IHN).

4. Système (200,300) d'émission multi-voies selon la revendication 1 dans lequel le signal de calibration est un signal large bande ou un signal bande étroite ayant une bande de fréquence variant temporellement dans toute la bande de fréquence du système.

5. Système (200,300) d'émission multi-voies selon l'une des revendications précédentes dans lequel le signal de calibration est périodique et l'extraction (EXT) d'une mesure du signal de calibration est réalisée en effectuant une accumulation temporelle cohérente du signal reçu sur l'entrée de calibration.

6. Système (400) d'émission multi-voies selon la revendication 1 dans lequel le signal de calibration est égal à un signal utile généré sur une entrée du réseau hybride d'entrée (IHN) et sauvegardé dans une mémoire (MEM).

7. Système (200,300,400) d'émission multi-voies selon l'une des revendications précédentes dans lequel chaque filtre égaliseur (201,202,203,204) est configuré pour corriger, sur toute la bande de fréquence du système, en amplitude et en phase les signaux de sortie du réseau hybride d'entrée (IHN) de manière à corriger les défauts d'appairage et d'isolation des différentes voies du système d'émission multi-voies.

8. Système (200,300,400) d'émission multi-voies selon l'une des revendications précédentes dans lequel chaque chaine de traitement analogique radiofréquence (221) comprend un dispositif de transposition de fréquence pour transposer le signal analogique d'une première fréquence vers une seconde fréquence et la chaine d'acquisition analogique radiofréquence (222) comprend un dispositif de transposition de fréquence inverse pour transposer un signal analogique de la seconde fréquence vers la première fréquence.

9. Charge utile de satellite comprenant un système (200,300,400) d'émission multi-voies selon l'une des revendications précédentes et au moins une antenne ou réseau antennaire (241) connecté en sortie dudit système.

## Patentansprüche

1. Mehrkanal-Sendesystem (200, 300, 400), das eine digitale Vorrichtung (DN), die so konfiguriert ist, dass sie ein hybrides Eingangsnetzwerk (IHN) mit mehreren Eingängen und mehreren Ausgängen implementiert, und ein getrenntes Entzerrfilter (201, 202, 203, 204) für jeden Ausgang des hybriden Eingangsnetzwerks (IHN) umfasst, wobei das System weiter umfasst:
- für jeden Ausgang der digitalen Vorrichtung (DN), der mit einem Ausgang eines jeweiligen Entzerrfilters verbunden ist, einen Digital-Analog-Wandler (211), gefolgt von einer analogen Hochfrequenz-Verarbeitungskette (221), die mindestens ein analoges Filter umfasst, und einem Verstärker (231),
- ein hybrides Ausgangsnetzwerk (OHN), von dem jeder Eingang mit dem Ausgang eines anderen Verstärkers (231) verbunden ist,
- eine analoge Hochfrequenz-Erfassungskette (222), die mindestens ein analoges Filter umfasst, wobei die analoge Hochfrequenz-Erfassungskette (222) über ihren Eingang abwechselnd mit dem Ausgang jedes Verstärkers (231), mittels eines Selektors (SEL), und über ihren Ausgang mit einem Kalibrierungseingang (EC) der digitalen Vorrichtung (DN), mittels eines Analog-Digital-Wandlers (212), verbunden wird, wobei die analoge Hochfrequenz-Erfassungskette (222) eine Funktion ausführt, die zu derjenigen der analogen Hochfrequenz-Verarbeitungsketten (221) invers ist,
wobei die digitale Vorrichtung (DN) weiter so konfiguriert ist, dass sie:
- ein Kalibriersignal an einem Eingang des hybriden Eingangsnetzwerks (IHN) erzeugt (GEN), wobei das Kalibriersignal das gesamte Spektralband des Systems belegt, wobei Nutzsignale mindestens an den anderen Eingängen des Hybriden Eingangsnetzwerks (IHN) vorliegen,
- aus dem an dem Kalibrierungseingang empfangenen Signal einen Messwert des Kalibriersignals extrahiert (EXT),
- nacheinander die Antwort jedes Entzerrfilters bestimmt (CALC), um eine Differenz zwischen dem erzeugten Kalibriersignal und dem gemessenen Kalibriersignal zu minimieren, wobei der Selektor (SEL) nacheinander mit dem Ausgang jedes Verstärkers verbunden wird,
wobei die Übertragungsfunktion des hybriden Eingangsnetzwerks (IHN) so bestimmt wird, dass sie die inverse Übertragungsfunktion des hybriden Ausgangsnetzwerks (OHN) ist.

2. Mehrkanal-Sendesystem (200) nach Anspruch 1, wobei das hybride Eingangsnetzwerk (IHN) so konfiguriert ist, dass es das Kalibriersignal an einem Kalibrierungseingang und ein Nutzsignal an den anderen Eingängen empfängt, und das hybride Ausgangsnetzwerk (OHN) einen Kalibrierungsausgang, der mit einer Last (Z) verbunden ist, und die anderen Ausgänge umfasst, die mit einer oder mehreren Antennen (241) verbunden sind.

3. Mehrkanal-Sendesystem (300) nach Anspruch 1, wobei das Kalibriersignal einem Nutzsignal an einem Eingang des hybriden Eingangsnetzwerks (IHN) überlagert ist.

4. Mehrkanal-Sendesystem (200, 300) nach Anspruch 1, wobei das Kalibriersignal ein Breitbandsignal oder ein Schmalbandsignal ist, das ein Frequenzband aufweist, das zeitlich in dem gesamten Frequenzband des Systems variiert.

5. Mehrkanal-Sendesystem (200, 300) nach einem der vorstehenden Ansprüche, wobei das Kalibriersignal periodisch ist und das Extrahieren (EXT) eines Messwerts des Kalibriersignals durch Vornehmen einer kohärenten zeitlichen Akkumulation des am Kalibrierungseingang empfangenen Signals erfolgt.

6. Mehrkanal-Sendesystem (400) nach Anspruch 1, wobei das Kalibriersignal gleich einem Nutzsignal ist, das an einem Eingang des hybriden Eingangsnetzwerks (IHN) erzeugt und in einem Speicher (MEM) gespeichert wird.

7. Mehrkanal-Sendesystem (200, 300, 400) nach einem der vorstehenden Ansprüche, wobei jedes Entzerrfilter (201, 202, 203, 204) so konfiguriert ist, dass es über das gesamte Frequenzband des Systems die Ausgangssignale des hybriden Eingangsnetzwerks (IHN) in Amplitude und Phase korrigiert, um die Pairing- und Isolationsfehler der verschiedenen Kanäle des Mehrkanal-Sendesystems zu korrigieren.

8. Mehrkanal-Sendesystem (200, 300, 400) nach einem der vorstehenden Ansprüche, wobei jede analoge Hochfrequenz-Verarbeitungskette (221) eine Frequenztranspositionsvorrichtung umfasst, um das analoge Signal von einer ersten Frequenz auf eine zweite Frequenz zu transponieren, und die analoge Hochfrequenz-Erfassungskette (222) eine inverse Frequenztranspositionsvorrichtung umfasst, um ein analoges Signal von der zweiten Frequenz auf die erste Frequenz zu transponieren.

9. Satellitennutzlast, die ein Mehrkanal-Sendesystem (200, 300, 400) nach einem der vorstehenden Ansprüche und mindestens eine Antenne oder ein Antennenarray (241) umfasst, die bzw. das mit dem Ausgang des Systems verbunden ist.

## Claims

1. Multi-channel transmission system (200, 300, 400) comprising a digital device (DN) configured to implement an input hybrid network (IHN) at multiple inputs and multiple outputs and an equaliser filter (201, 202, 203, 204) distinct for each output of the input hybrid network (IHN), the system further comprising:
- for each output, a digital device (DN) connected to an output of a respective equaliser filter, a digital-to-analogue converter (211) followed by a radiofrequency analogue processing chain (221), comprising at least one analogue filter, and an amplifier (231),
- an output hybrid network (OHN), of which each input is connected to the output of a different amplifier (231),
- a radiofrequency analogue acquisition chain (222) comprising at least one analogue filter, the radiofrequency analogue acquisition chain (222) being connected by its input, alternatively, to the output of each amplifier (231) through a selector (SEL), and by its output to a calibration input (EC) of the digital device (DN) through an analogue-to-digital converter (212), the radiofrequency analogue acquisition chain (222) performing a function opposite to that of the radiofrequency analogue processing chains (221),
the digital device (DN) further being configured to:
- generate (GEN) a calibration signal on an input of the input hybrid network (IHN), the calibration signal occupying the entire spectral band of the system, useful signals being present at least one the other inputs of the input hybrid network (IHN),
- extract (EXT), from the signal received on the calibration input, a measurement of the calibration signal,
- determine (CALC) successively the response of each equaliser filter so as to minimise a difference between the generated calibration signal and the measured calibration signal, the selector (SEL) being connected successively to the output of each amplifier,
the transfer function of the input hybrid network (IHN) is determined to be the opposite transfer function of the output hybrid network (OHN).

2. Multi-channel transmission system (200) according to claim 1, wherein the input hybrid network (IHN) is configured to receive the calibration signal on a calibration input and a useful signal on the other inputs and the output hybrid network (OHN) comprises a calibration output connected to a charge (Z) and the other outputs connected to one or more antennas (241).

3. Multi-channel transmission system (300) according to claim 1, wherein the calibration signal is superimposed to a useful signal on an input of the input hybrid network (IHN).

4. Multi-channel transmission system (200, 300) according to claim 1, wherein the calibration signal is a broadband signal or a narrowband signal having a frequency range varying temporally in the entire frequency range of the system.

5. Multi-channel transmission system (200, 300) according to any one of the preceding claims, wherein the calibration system is periodic and the extraction (EXT) of a measurement of the calibration system is performed by performing a coherent time accumulation of the signal received on the calibration input.

6. Multi-channel transmission system (400) according to claim 1, wherein the calibration signal is equal to a useful signal generated on an input of the input hybrid network (IHN) and saved in a memory (MEM).

7. Multi-channel transmission system (200, 300, 400) according to any one of the preceding claims, wherein each equaliser filter (201, 202, 203, 204) is configured to correct, over the entire frequency range of the system, by amplitude and by phase of the output signals of the input hybrid network (IHN), so as to correct the pairing and insulation defects of the different channels of the multi-channel transmission system.

8. Multi-channel transmission system (200, 300, 400) according to any one of the preceding claims, wherein each radiofrequency analogue processing chain (221) comprises a frequency transposition device to transpose the analogue signal of a first frequency to a second frequency, and the radiofrequency analogue acquisition chain (222) comprises an opposite frequency transposition device to transpose an analogue signal of the second frequency to the first frequency.

9. Satellite payload comprising a multi-channel transmission system (200, 300, 400) according to any one of the preceding claims, and at least one antenna or antenna network (241) connected to the output of said system.
